# EUROPEAN PATENT SPECIFICATION

(11) **EP 0 496 171 B1**
(45) Date of publication and mention of the grant of the patent: **05.03.1997**
(21) Application number: 91312097.8
(22) Date of filing: 31.12.1991
(51) Int. Cl.: H03K 3/037, H03K 3/01

(54) **Bistable semiconductor integrated circuit**
Bistabile integrierte Halbleiterschaltung
Circuit intégré semi-conducteur bistable

(30) Priority: 25.01.1991 JP 25549/91
(43) Date of publication of application: 29.07.1992
(73) Proprietor: KABUSHIKI KAISHA TOSHIBA, Kawasaki-shi, Kanagawa-ken 210 (JP)
(72) Inventor: Hasegawa, Takehiro, c/o Intellectual Property Div., Minato-ku, Tokyo 105 (JP); Kameyama, Atsushi, c/o Intellectual Property Div., Minato-ku, Tokyo 105 (JP)
(74) Representative: Waldren, Robin Michael

(56) References cited:
- EP-A- 0 213 647
- EP-A- 0 492 943
- DE-A- 3 044 835
- DE-A- 3 813 550
- US-A- 4 873 456
- US-A 4 591 737
- EP-A 0 306 234
- IBM Technical Disclosure Bulletin, Vol. 15, No. 7, December 1972, page 2077

## Description

This invention relates to a semiconductor integrated circuit composed of flip-flops, which receives data with the timing of a clock signal and retains it.

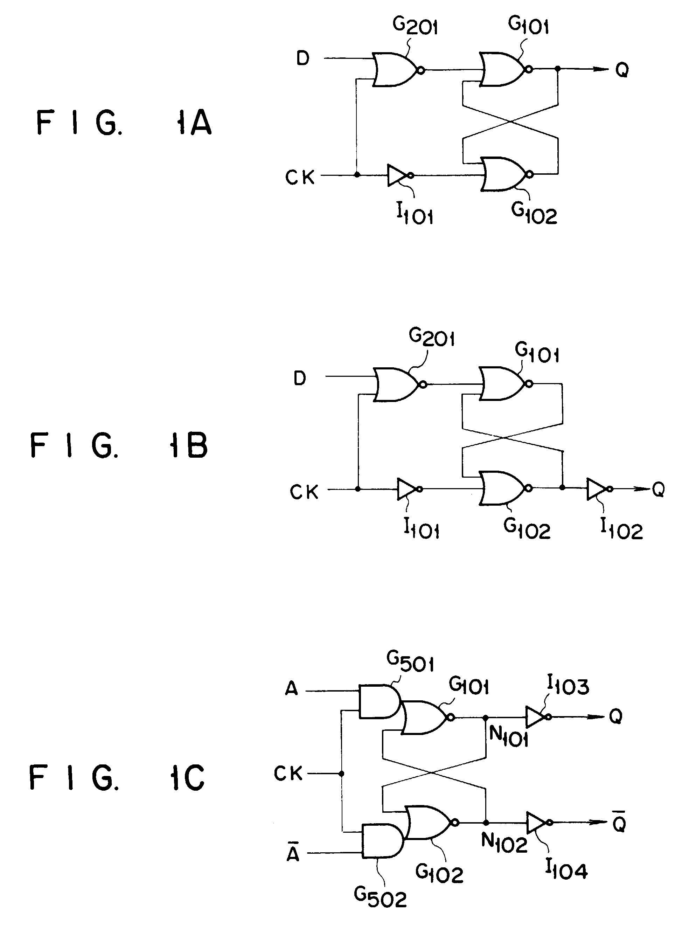

Conventional data latch circuits are constructed as shown in Fig. 1A, for example. They are composed primarily of flip-flops using NOR gates. Specifically, the data latch circuit is made up of NOR gates G₁₀₁ and G₁₀₂ constituting a flip-flop, a NOR gate G₂₀₁ serving as an input gate that transfers data D to one input terminal of the flip-flop under the control of clock CK supplied to one input terminal of this gate, and an inverter I₁₀₁ that inverts clock CK and supplies it to the other input terminal of the flip-flop.

To increase the current driving capacity of the data latch, for example, an inverter buffer I₁₀₂ is provided as an output buffer as shown Fig. 1B. In the Fig. 1B data latch circuit with the output buffer, data taken in on clock has to pass through three stages of gate G₁₀₁, gate G₁₀₂, and inverter buffer I₁₀₂ before it reaches the output terminal. This delays the data transfer between the input and output in the data latch circuit.

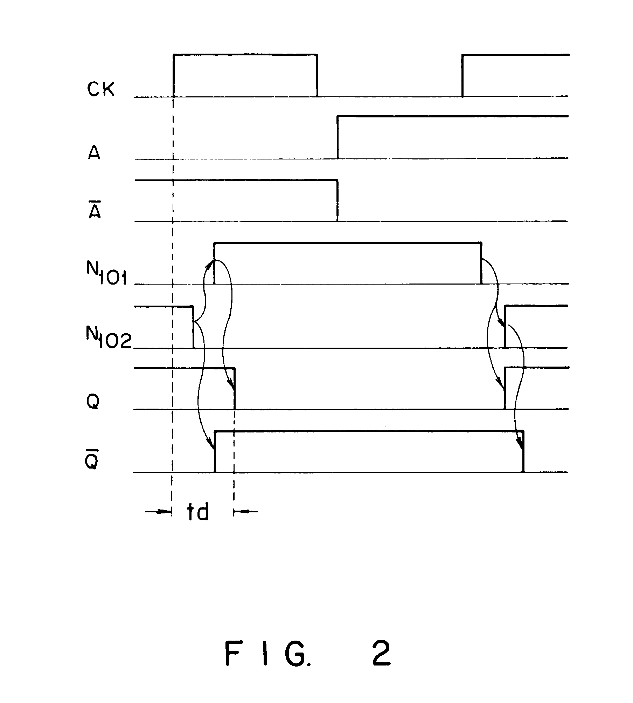

Fig. 1C shows another conventional flip-flop circuit, which is composed of NOR gates G₁₀₁ and G₁₀₂ constituting a flip-flop stage, AND gates G₅₀₁ and G₅₀₂ serving as input gates, and inverter buffers I₁₀₃ and I₁₀₄ serving as output buffers. Like the Fig. 1B data latch circuit, this flip-flop circuit also has a data delay due to three gate stages. Data delay will be explained, referring to the timing chart in Fig. 2. Assume that while data output Q is in the "1" state and the inverse data output of Q, /Q is in the "0" state, data consisting of A="0" and /A="1" is supplied. Here, to cause the input data to appear at the output Q, it is necessary for data /A to cause the output node N₁₀₂ of NOR gate G₁₀₂ to change from "1" to "0", which then causes the output node N₁₀₁ of NOR gate G₁₀₁ to change from "0" to "1", thereby changing the output of inverter buffer I₁₀₃ from "1" to "0". Therefore, data must pass through three gates, NOR gates G₁₀₂ and G₁₀₁, and inverter buffer I₁₀₃.

The same is true for D flip-flop circuits and the slave stage of master-slave flip-flop circuits.

As noted above, in various types of conventional flip-flop and data latch circuits, there is a delay introduced by three stages of gates from when data is supplied to the flip-flop stage and when it appears at the output terminal of the output buffer. Such a delay has been an obstacle to faster data processing.

For technical literature related to the present invention, reference may be made to Steven I. Long et al., "High Speed GaAs Integrated Circuit," Proceeding of The IEEE, Vol. 70, No. 1, Jan. 1982, pp. 35-45 and Y. Kamatani et al.,"DIVIDE BY 128/129 5 mW 400 MHz BAND GaAs PRESCALAR IC," IEEE, 1985, GaAs IC Symposium.

The object of the present invention is to provide an improved semiconductor integrated circuit, particularly a flip-flop-based semiconductor integrated circuit capable of high-speed operation.

This is accomplished by providing an integrated circuit comprising:
a first input gate having a first input terminal connected to an inversion signal of a clock, a second input terminal and a first output terminal;
a second input gate having a third input terminal connected to the inversion signal of the clock, a fourth input terminal and a second output terminal;
a first flip-flop circuit having a fifth input terminal connected to said first output terminal, a sixth input terminal connected to said second output terminal, a third output terminal for outputting an inverted output of said fifth input terminal and a fourth output terminal for outputting an inverted output of said sixth input terminal;
a first output gate having a seventh input terminal connected to said third output terminal, an eighth input terminal connected to said clock, a ninth input terminal connected to said second output terminal and a fifth output terminal;
a second output gate having a tenth input terminal connected to said fourth output terminal, an eleventh input terminal connected to said clock, a twelfth input terminal connected to said first output terminal and a sixth output terminal;
a second flip-flop circuit having a thirteenth input terminal connected to said fifth output terminal, a fourteenth input terminal connected to said sixth output terminal, a seventh output terminal for outputting an inverted output of said thirteenth input terminal and an eighth output terminal for outputting an inverted output of said fourteenth input terminal, the seventh output terminal being connected to the fourth input terminal and the eighth output terminal being connected to the second input terminal;
a third output gate having a fifteenth input terminal connected to said seventh output terminal, a sixteenth input terminal connected to said sixth output terminal and a ninth output terminal; and
a fourth output gate having a seventeenth input terminal connected to said eighth output terminal, an eighteenth input terminal connected to said fifth output terminal and a tenth output terminal.

With this configuration, the output buffer is provided with an advance read function, thereby eliminating a delay due to two stages of gates of the flip-flop in transferring data to the output terminal. This approach has no adverse effect on the data retaining function of the flip-flop stage. Consequently, the present invention provides various types of flip-flop circuits and data latch circuits with very small data delays.

In this way, providing the output buffer with an advance read function eliminates the adverse effects of the internal delays in various types of flip-flop circuits and data latch circuits, which helps make semiconductor integrated circuits operate faster.

This invention can be more fully understood from the following detailed description when taken in conjunction with the accompanying drawings, in which:
Figs. 1A to 1C are circuit diagrams for various types of conventional semiconductor integrated circuits;
Fig. 2 is a timing chart for explaining the operation of the flip-flop of Fig. 1C;
Fig. 3 is a block diagram for an RS flip-flop having an input gate;
Fig. 4 is a circuit diagram for the flip-flop circuit of Fig. 3;
Fig. 5 is a timing chart for explaining the operation of the flip-flop of Fig. 4;
Fig. 6 is a circuit diagram for a modification of the flip-flop of Fig. 4;
Fig. 7 is a block diagram for another RS flip-flop having an input gate;
Fig. 8 is a circuit diagram for the flip-flop circuit of Fig. 7;
Figs 9A to 9C are circuit diagrams for the composite gates of Fig. 8;
Fig. 10 is a block diagram for a data latch circuit;
Fig. 11 is a block diagram for another data latch circuit;
Fig. 12 is a circuit diagram for another data latch circuit;
Fig. 13 is a circuit diagram for another data latch circuit;
Fig. 14 is a circuit diagram for another data latch circuit;
Fig. 15 is a circuit diagram for another data latch circuit;
Fig. 16 is a circuit diagram for another data latch circuit;
Fig. 17 is a circuit diagram for a master-slave flip-flop;
Fig. 18 is a circuit diagram for another master-slave flip-flop;
Fig. 19 is a circuit diagram for another master-slave flip-flop;
Fig. 20 is a circuit diagram for an embodiment of a master-slave flip-flop according to the present invention; and
Fig. 21 is a circuit diagram for a D flip-flop.

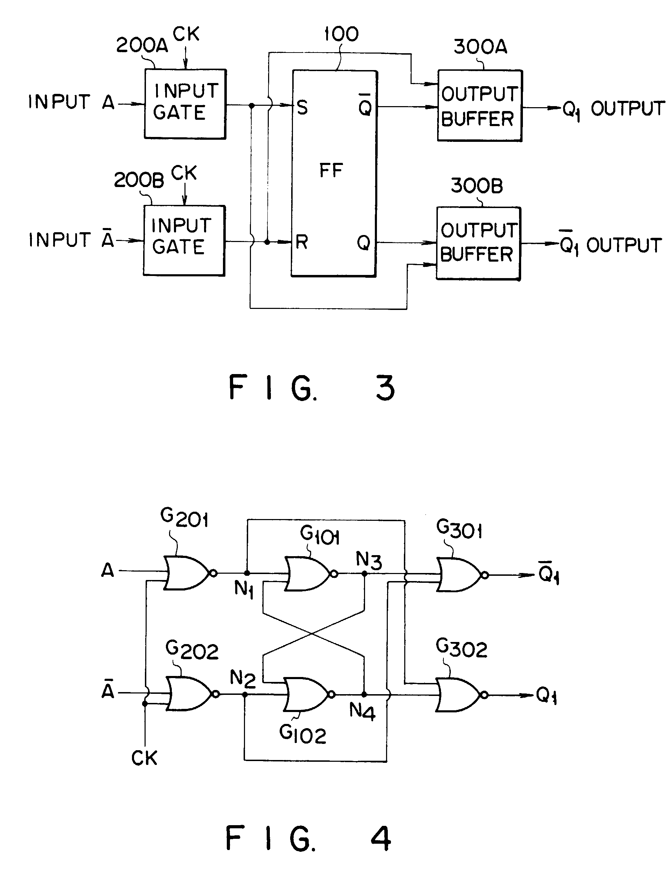

Fig. 3 is a block diagram for an RS flip-flop circuit having an input gate. The set input terminal S and reset input terminal R of an RS flip-flop 100 are provided respectively with input gates 200A and 200B, which transfer input data under the control of clock CK. The set output terminal Q and reset output terminal /Q are provided with output buffers 300B and 300A, respectively. The output buffer 300B is supplied with the data from the set output terminal Q and the data supplied to the set input terminal S. That is, the data to the set input terminal S is supplied to the output buffer 300B prior being transferred through the flip-flop 100, to provide the buffer with an advance read function. Similarly, the output buffer 300A, like the output buffer 300B, is supplied with the data from the reset output terminal /Q and the data supplied to the reset input terminal R.

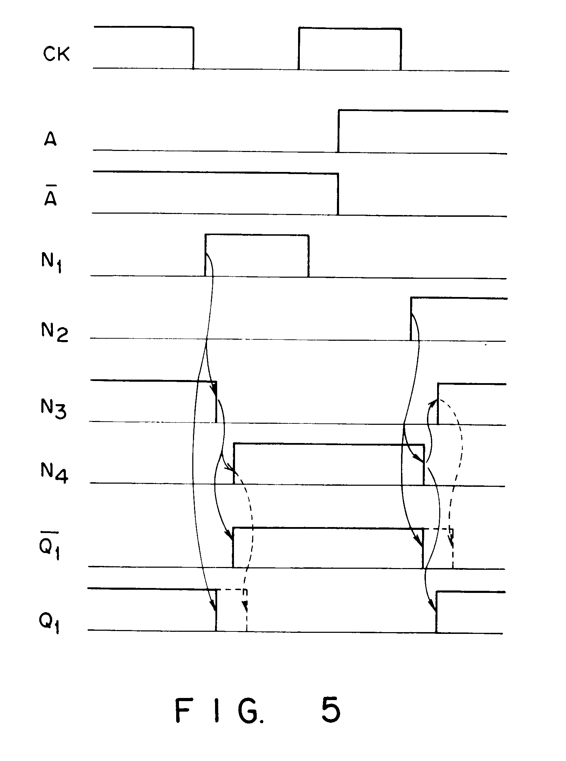

Fig. 4 is a circuit diagram for the flip-flop circuit of Fig. 3. The RS flip-flop 100 is made up of two NOR gates G₁₀₁ and G₁₀₂. The input gates 200A and 200B are composed of NOR gates G₂₀₁ and G₂₀₂, respectively. The output buffer 300A and 300B are composed of NOR gates G₃₀₁ and G₃₀₂. One NOR gate G₃₀₁ of the output buffer stage is connected to the output node N₃ of the flip-flop stage and the input node N₂. The other NOR gate G₃₀₂ of the output buffer stage is connected to the output node N₄ of the flip-flop stage and the input node N₁.

Fig. 5 is a timing chart for explaining the operation of the flip-flop circuit of Fig. 4. It is assumed that in the initial state, clock CK is a "1", data A a "0", data /A a "1", nodes N₁ and N₂ a "0", N₃ a "1", N₄ a "0", output Q₁ a "1", and output /Q₁ a "0". The change of clock CK from "1" to "0" causes node N₁ to change from "0" to "1". This change at node N₁ then causes the voltage at the output node N₃ of NOR gate G₁₀₁ to fall. This falling voltage at the output node N₃ in turn causes the voltage at the output node N₄ of NOR gate G₁₀₂ to rise. In conventional output buffers without an advance read function, as shown by broken lines in Fig. 5, as a result of the rising signal from the output node N₄, the output Q₁ of NOR gate G₃₀₂ of the output buffer stage goes to "0". However, as shown by solid lines, with an advance read function a rise in the voltage at input node N₁ is supplied directly to NOR gate G₃₀₂ of the output buffer stage, which causes the output Q₁ to fall. Therefore, the final output Q₁="0" can be obtained without introducing a delay due to two NOR gates G₁₀₁ and G₁₀₂ constituting the RS flip-flop circuit 100. The same is true in a case where the input data of A="1" and /A="0" is taken in on clock CK and retained. Here, the final output /Q₁="0" is obtained without a delay due to two NOR gates found in conventional circuits.

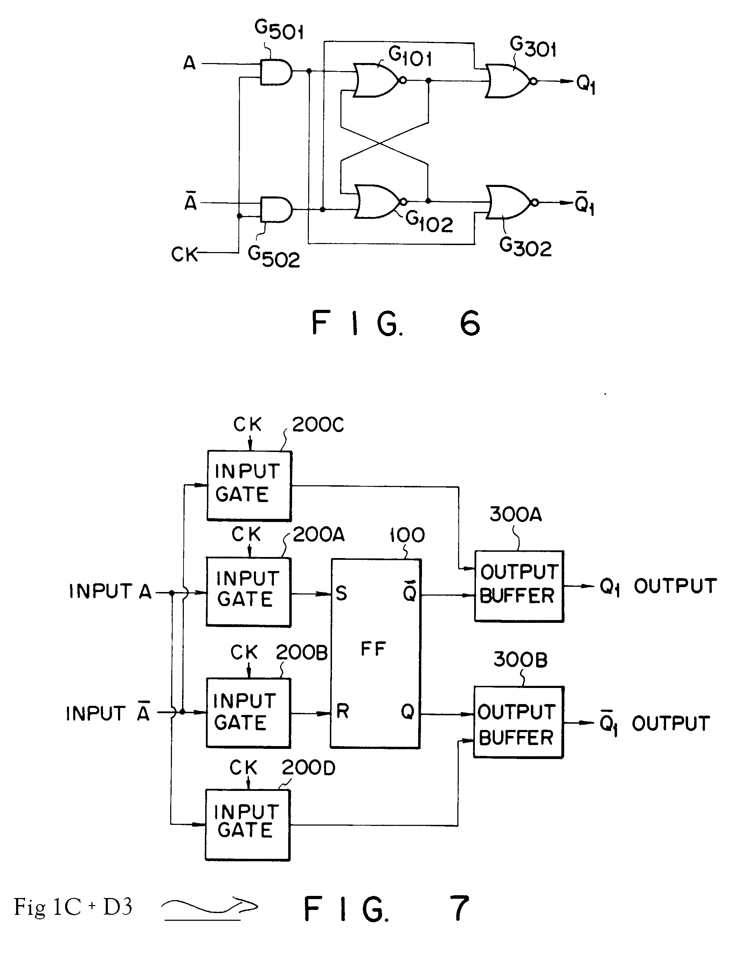

Fig. 6 is a circuit diagram for a modification of the flip-flop circuit of Fig. 4. In this circuit, AND gates G₅₀₁ and G₅₀₂ replace the NOR gates G₂₀₁ and G₂₀₂ constituting the input gate of Fig. 4. The AND gate G₅₀₁ and G₅₀₂ may be such as source-follower AND gates.

Fig. 7 is a block diagram for another RS flip-flop circuit having an input gate.

In this circuit, in addition to the input gates 200A and 200B for transferring data to the RS flip-flop 100, input gates 200C and 200D are provided to give the output buffers 300A and 300B an advance read function.
The composite gate arrangement of the input gates 200A and 200B and RS flip-flop 100 is useful particularly in cases where the set input terminal S and reset input terminal R cannot be connected directly to the output buffers 300B and 300A.

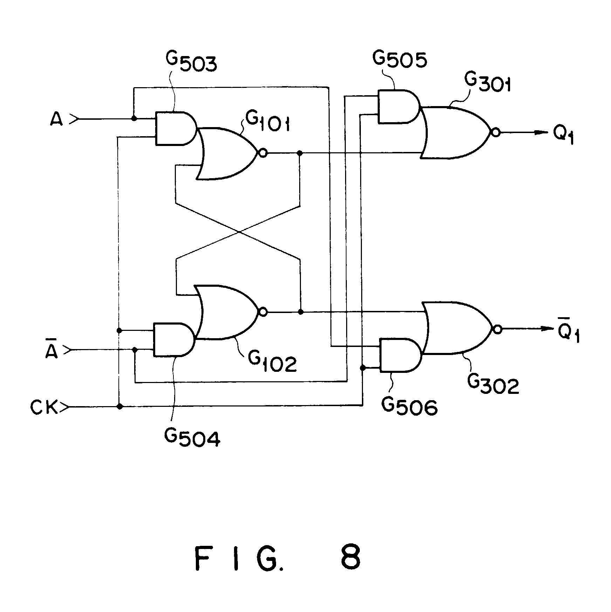

Fig. 8 is a circuit diagram for the RS flip-flop circuit of Fig. 7. In this circuit, NOR gates G₁₀₁ and G₁₀₂ constitute the RS flip-flop circuit 100. In the input gates 200A and 200B, AND gates G₅₀₃ and G₅₀₄ are combined with NOR gates G₁₀₁ and G₁₀₂, respectively, to form composite gates. AND gates G₅₀₅ and G₅₀₆, which provide an advance read function for NOR gates G₃₀₁ and G₃₀₂ constituting the output buffers 300A and 300B, correspond to the input gates 200C and 200D, respectively. In this way, the output buffer section is also constructed to form a composite gate arrangement of AND and NOR elements.

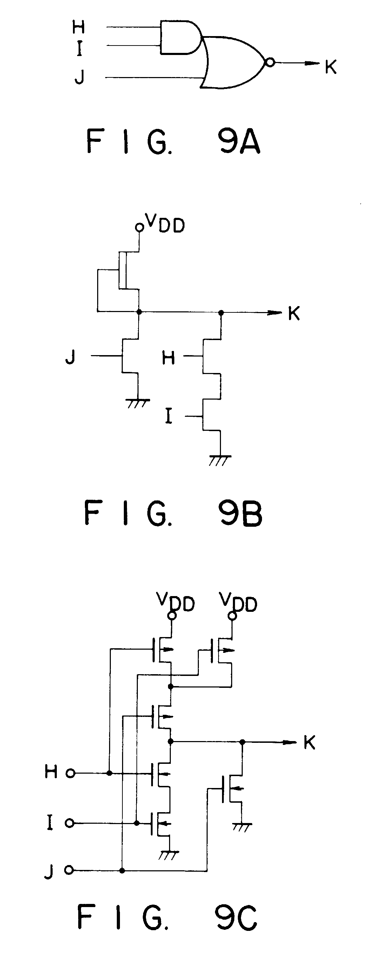

Examples of the AND-to-NOR composite gate arrangement of Fig. 8 are shown in Fig. 9A to 9C. Fig. 9A illustrates an equivalent circuit of gate level, Fig. 9B shows a circuit diagram for the Fig. 9A circuit constructed of MESFETs, and Fig. 9C depicts a circuit diagram for Fig. 9A circuit constructed of CMOS circuits.

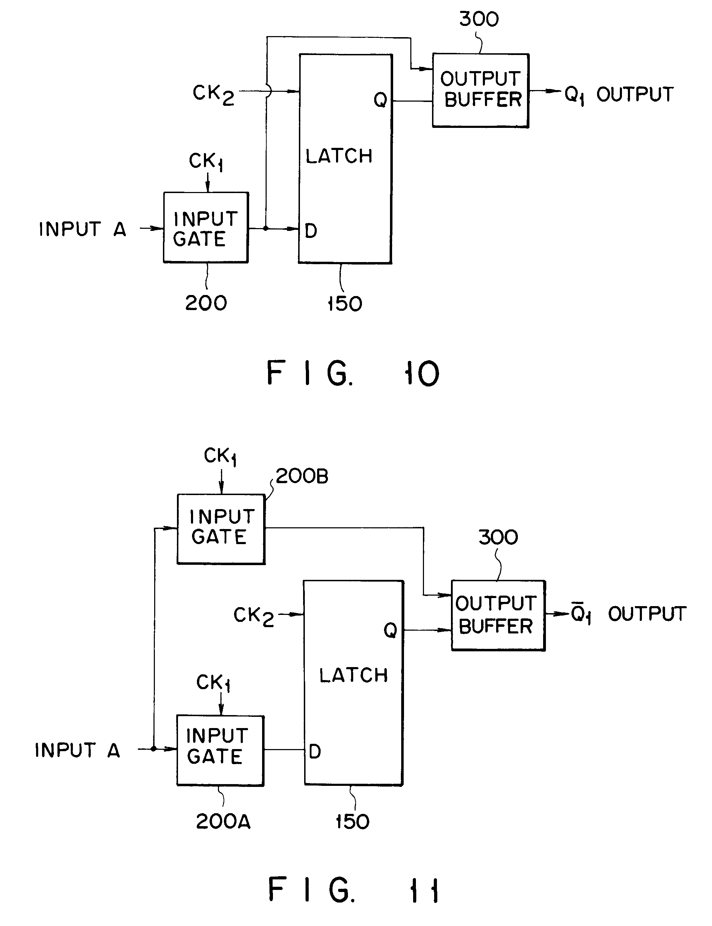

Figs. 10 to 16 illustrate data latch circuits.

Fig. 10 is a block diagram for a data latch circuit. A flip-flop 150 for latching data has the data input terminal D, the input terminal for clock CK₂, and the output terminal Q. The data input terminal D is connected to an input gate 200 that transfers input data under the control of clock CK₁. The data output terminal Q is connected to an output buffer 300. As in those circuits described above, the output buffer 300 is provided with an advance read function that allows the input data to be supplied directly to this buffer before the input passing through the data-latch flip-flop 150. Therefore, as with the above circuits, this circuit provides the output without introducing a delay due to two stages of gates of the data-latch flip-flop 150.

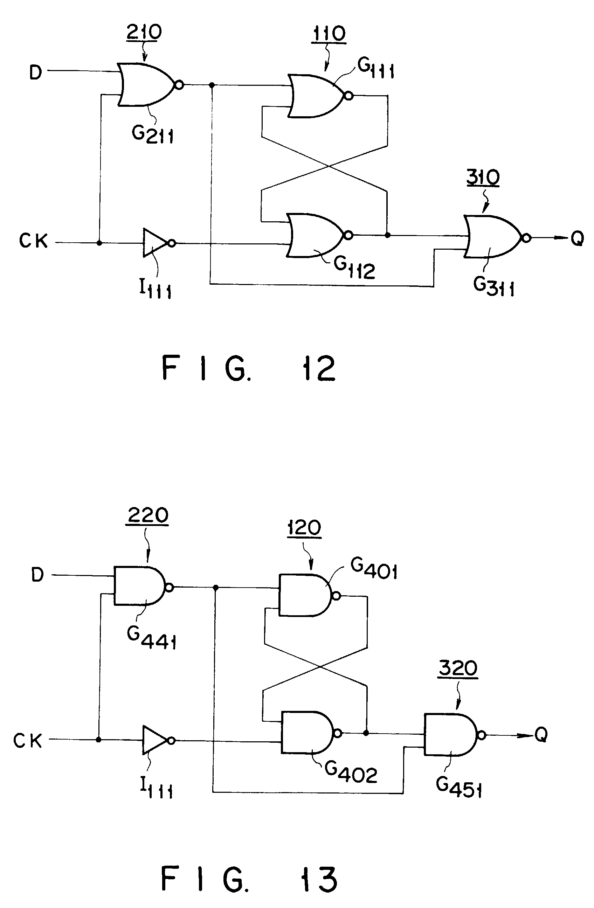

Fig. 11 is a block diagram for another data latch circuit. Another input gate 200Bis provided in parallel with the input gate 200A to give the output buffer 300 an advance read function. Like the circuit explained in Fig. 7, this arrangement is useful for composite gate arrangements.

Fig. 12 is a block diagram for another data latch circuit.

The data latch circuit of Fig. 12 is made up of a NOR gate G211 forming the input gate stage 210, NOR gates G₁₁₁ and G₁₁₂ constituting a flip-flop stage 110, and a NOR gate G₃₁₁ forming the output buffer stage 310. The clock CK is supplied directly to the NOR gate G211 of the input gate stage 210, and at the same time, is supplied via an inverter gate I₁₁₁ to the NOR gate G₁₁₂ of the flip-flop stage. unlike ordinary data latch circuits, in this circuit, the signal at the output node of the input gate stage 210 is supplied to the NOR gate G₃₁₁ of the output buffer 310 to provide an advance read function.

Fig. 13 is a block diagram for another latch circuit.

The data latch circuit of Fig. 13 is composed of a NAND gate G₄₄₁ forming the input gate stage 220, NAND gates G₄₀₁ and G₄₀₂ constituting the flip-flop stage 120, and a NAND gate G₄₅₁ forming the output buffer stage 320. The clock CK is supplied directly to the NAND gate G₄₄₁ of the input gate stage 220, and at the same time, is supplied via the inverter gate I₁₁₁ to the NOR sate G₄₀₂ of the flip-flop stage. Unlike ordinary data latch circuits. this circuit allows the signal at the output node of the input gate stage 220 to be supplied to the NAND gate G₄₅₁ of the output buffer 320 to provide an advance read function.

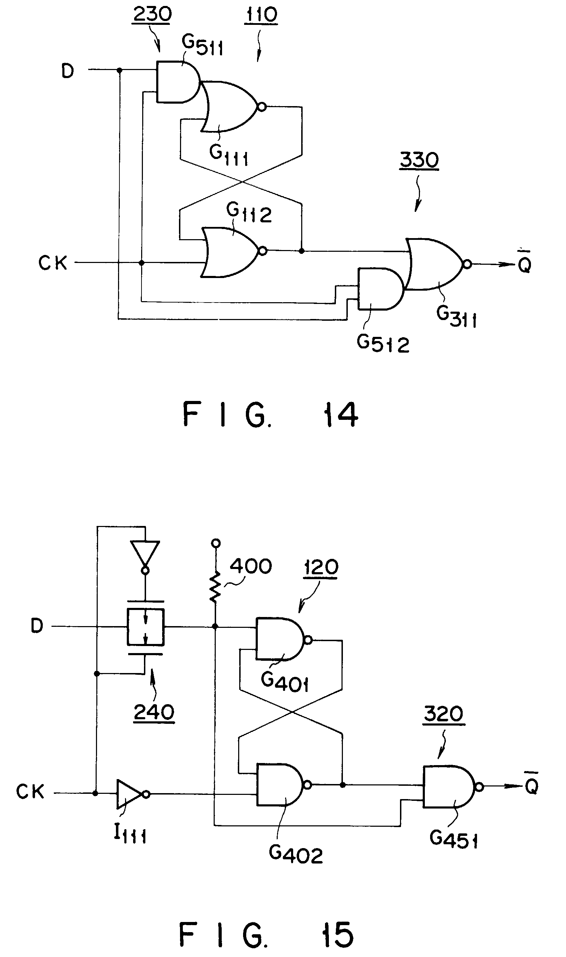

Fig. 14 is a block diagram of another data latch circuit.

In the data latch circuit of Fig. 14, the flip-flop stage 110 is made up of NOR gates G₁₁₁ and G₁₁₂. The NOR gate G₁₁₁ and an AND gate G₅₁₁ forming the input gate stage 230 are combined to form an AND-to-NOR composite gate arrangement. The output buffer stage 330 is made up of the NOR gate G₃₁₁. The NOR gate G₃₁₁ and an AND gate G₅₁₂ are combined to form a composite gate arrangement to provide the output buffer 330 with an advance read function.

Fig. 15 is a block diagram for another data latch circuit.

In the data latch circuit of Fig. 15, the input gate stage 220 of Fig. 13 is constructed of a CMOS transfer gate 240. The resistor 400 is designed to present enough resistance for the output node of the transfer gate 220 to go to the "1" level only when the transfer gate 220 turns off.

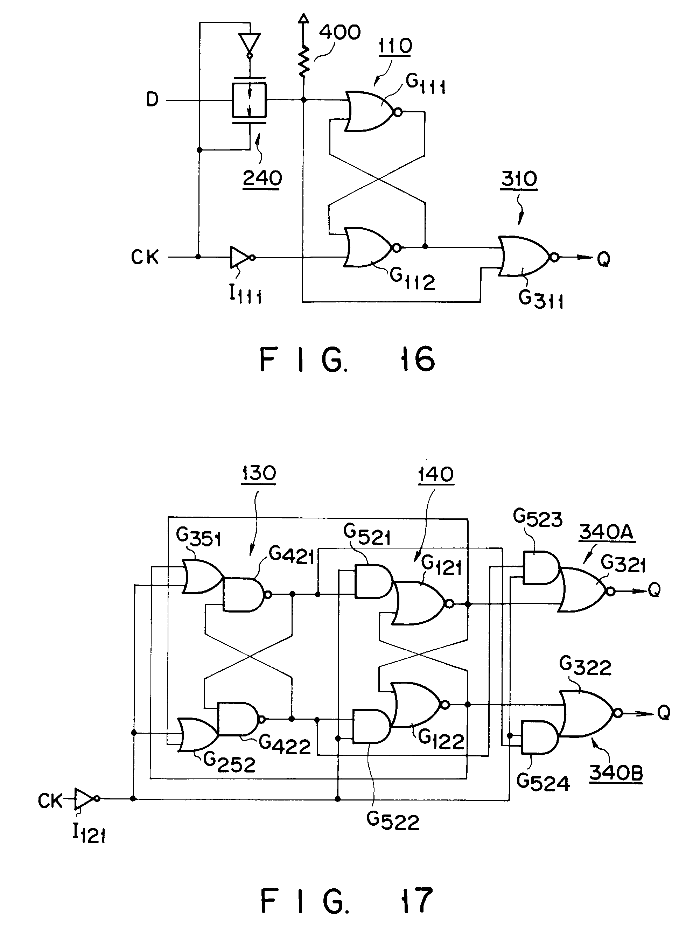

Fig. 16 is a block diagram for another data latch circuit.

In the data latch circuit of Fig. 16, the input gate stage 230 of Fig. 14 is constructed of a CMOS transfer gate 240. With this configuration, because the output node of the input gate 230 can be connected to the output buffer, this provides an advance read function without the AND gate G₅₁₂ of Fig. 14. The resistor 400 is designed to present enough resistance for the output node of the transfer gate 230 to go to the "0" level only when the transfer gate turns off, and to maintain the node potential.

The data latch circuits shown in Figs. 10 to 16, like the above-described circuits, eliminate the effects of internal delay and enable high speed operation.

Fig. 17 is a circuit diagram for a master-slave flip-flop circuit.

The master flip-flop stage 130 is composed of NAND gates G₄₂₁ and G₄₂₂ constituting a flip-flop and OR gates G₃₅₁ and G₃₅₂ forming transfer gates, all of which are integrated into an OR-to-NAND composite arrangement. The slave flip-flop stage 140 is composed of NOR gates G₁₂₁ and G₁₂₂ constituting a flip-flop and AND gates G₅₂₁ and G₅₂₂ forming transfer gates, all of which are integrated into a NAND-to-NOR composite arrangement. The output buffers 340A and 340B each consist of AND-to-NOR composite gates, into which NOR gates G₃₂₁ and G₃₂₂ and AND gates G₅₂₃ and G₅₂₄ for providing an advance read function are integrated, respectively.

As in the preceding arrangements, while data is still in the course of passing through the slave flip-flop stage 140, the AND gates G₅₂₃ and G₅₂₄ allow a change in the signal at the output node of the master flip-flop stage 130 to appear at the output buffers 340A and 340B as a change in the output, thereby shortening data delay.

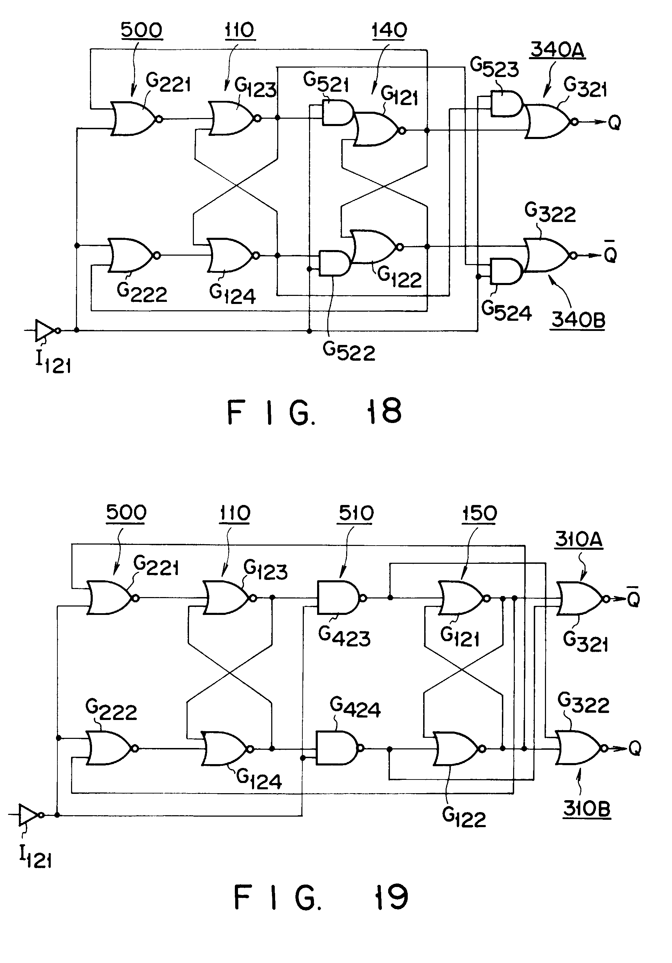

Fig. 18 is a circuit diagram for another master-slave flip-flop circuit.

In the master-slave flip-flop circuit of Fig. 18, the master stage is composed of the master flip-flop 110 consisting of NOR gates G₁₂₃ and G₁₂₄ and a separate transfer gate 500 consisting of NOR gates G₂₀₁ and G₂₂₂.

Fig. 19 is a circuit diagram for another master-slave flip-flop circuit.

In the master-slave flip-flop circuit of Fig. 19, the master-slave flip-flop circuit of Fig. 18 is modified in that the slave stage is also composed of the flip-flop 150 consisting of NOR gates G₁₂₁ and G₁₂₂ and a separate transfer gate 510 consisting of NAND gates G₄₂₃ and G₄₂₄. Here, the output buffers 310A and 310B consist only of NOR gates G₃₂₁ and G₃₂₂, respectively. The output nodes of the NAND gates G₄₂₃ and G₄₂₄ of the transfer gate stage 510 are connected to the output buffers 310B and 310A, respectively, to provide these buffers with an advance read function.

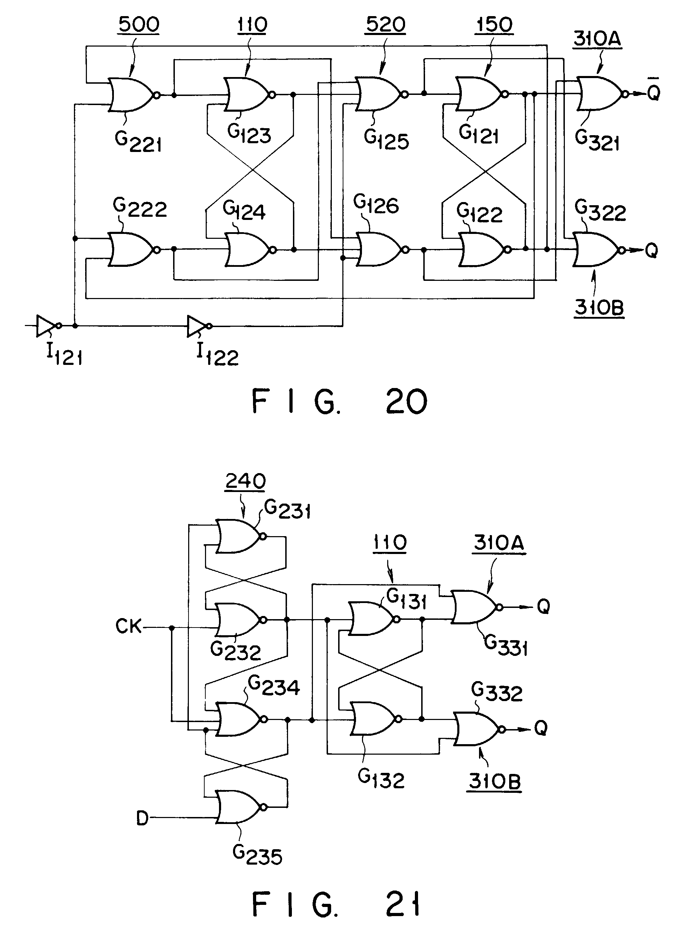

Fig. 20 is a circuit diagram for an embodiment of a master-slave flip-flop circuit according to the present invention. In the master-slave flip-flop circuit of Fig. 20, the NAND gates of the transfer gate stage 510 of the master-slave flip-flop circuit of Fig. 19 is replaced by NOR gates G₁₂₅ and G₁₂₆, which forms the transfer gate stage 520.

Fig. 21 is a D flip-flop. The input gate stage 240 is composed of NOR gates G₂₃₁, G₂₃₂, G₂₃₄, and G₂₃₅, the flip-flop stage 110 is made up of NOR gates G₁₃₁ and G₁₃₂, and the output buffers 310A and 310B consist of NOR gates G₃₃₁ and G₃₃₂, respectively. This D flip-flop differs from ordinary D flip-flops in that the output nodes of the input gate stage 240 are connected to the output buffers 310A and 310B to provide these buffers with an advance read function. Consequently, shorter data delays are achieved.

## Claims

1. An integrated circuit comprising:
a first input gate (G221) having a first input terminal connected to an inversion signal of a clock, a second input terminal and a first output terminal;
a second input gate (G222) having a third input terminal connected to the inversion signal of the clock, a fourth input terminal and a second output terminal;
a first flip-flop circuit (110) having a fifth input terminal connected to said first output terminal, a sixth input terminal connected to said second output terminal, a third output terminal for outputting an inverted output of said fifth input terminal and a fourth output terminal for outputting an inverted output of said sixth input terminal;
a first output gate (G125) having a seventh input terminal connected to said third output terminal, an eighth input terminal connected to said clock, a ninth input terminal connected to said second output terminal and a fifth output terminal;
a second output gate (G126) having a tenth input terminal connected to said fourth output terminal, an eleventh input terminal connected to said clock, a twelfth input terminal connected to said first output terminal and a sixth output terminal;
a second flip-flop circuit (150) having a thirteenth input terminal connected to said fifth output terminal, a fourteenth input terminal connected to said sixth output terminal, a seventh output terminal for outputting an inverted output of said thirteenth input terminal and an eighth output terminal for outputting an inverted output of said fourteenth input terminal, the seventh output terminal being connected to the fourth input terminal and the eighth output terminal being connected to the second input terminal;
a third output gate (G321) having a fifteenth input terminal connected to said seventh output terminal, a sixteenth input terminal connected to said sixth output terminal and a ninth output terminal; and
a fourth output gate (G322) having a seventeenth input terminal connected to said eighth output terminal, an eighteenth input terminal connected to said fifth output terminal and a tenth output terminal.

2. An integrated circuit according to claim 1, wherein at least one of said input gates, flip-flops and output gates includes a NAND gate.

3. An integrated circuit according to claim 1, wherein at least one of said input gates, flip-flops and output gates includes a NOR gate.

## Patentansprüche

1. Integrierte Schaltung mit:
einem ersten Eingangsgatter (G221) mit einem ersten Eingangsanschluß, der mit einem Inversionssignal eines Taktes beaufschlagt ist, einem zweiten Eingangsanschluß und einem ersten Ausgangsanschluß,
einem zweiten Eingangsgatter (G222) mit einem dritten Eingangsanschluß, der mit dem Inversionssignal des Taktes beaufschlagt ist, einem vierten Eingangsanschluß und einem zweiten Ausgangsanschluß,
einer ersten Flipflopschaltung (110) mit einem fünften Eingangsanschluß, der mit dem ersten Ausgangsanschluß verbunden ist, einem sechsten Eingangsanschluß, der mit dem zweiten Ausgangsanschluß verbunden ist, einem dritten Ausgangsanschluß zum Abgeben eines invertierten Ausgangssignales des fünften Eingangsanschlusses und einem vierten Ausgangsanschluß zum Abgeben eines invertierten Ausgangssignales des sechsten Eingangsanschlusses,
einem ersten Ausgangsgatter (G125) mit einem siebenten Eingangsanschluß, der mit dem dritten Ausgangsanschluß verbunden ist, einem achten Eingangsanschluß, der mit dem Takt beaufschlagt ist, einem neunten Eingangsanschluß, der mit dem zweiten Ausgangsanschluß verbunden ist, und einem fünften Ausgangsanschluß,
einem zweiten Ausgangsgatter (G126) mit einem zehnten Eingangsanschluß, der mit dem vierten Ausgangsanschluß verbunden ist, einem elften Eingangsanschluß, der mit dem Takt beaufschlagt ist, einem zwölften Eingangsanschluß, der mit dem ersten Ausgangsanschluß verbunden ist, und einem sechsten Ausgangsanschluß,
einer zweiten Flipflopschaltung (150) mit einem dreizehnten Eingangsanschluß, der mit dem fünften Ausgangsanschluß verbunden ist, einem vierzehnten Eingangsanschluß, der mit dem sechsten Ausgangsanschluß verbunden ist, einem siebenten Ausgangsanschluß zum Abgeben eines invertierten Ausgangssignales des dreizehnten Eingangsanschlusses und einem achten Ausgangsanschluß zum Abgeben eines invertierten Ausgangssignales des vierzehnten Eingangsanschlusses, wobei der siebente Ausgangsanschluß mit dem vierten Eingangsanschluß und der achte Ausgangsanschluß mit dem zweiten Eingangsanschluß verbunden sind,
einem dritten Ausgangsgatter (G321) mit einem fünfzehnten Eingangsanschluß, der mit dem siebten Ausgangsanschluß verbunden ist, einem sechzehnten Eingangsanschluß, der mit dem sechsten Ausgangsanschluß verbunden ist, und einem neunten Ausgangsanschluß, und
einem vierten Ausgangsgatter (G322) mit einem siebzehnten Eingangsanschluß, der mit dem achten Ausgangsanschluß verbunden ist, einem achtzehnten Eingangsanschluß, der mit dem fünften Ausgangsanschluß verbunden ist, und einem zehnten Ausgangsanschluß.

2. Integrierte Schaltung nach Anspruch 1, bei der wenigstens eines der Eingangsgatter, Flipflops und Ausgangsgatter ein NAND-Gatter umfaßt.

3. Integrierte Schaltung nach Anspruch 1, bei der wenigstens eines der Eingangsgatter, Flipflops und Ausgangsgatter ein NOR-Gatter umfaßt.

## Revendications

1. Circuit intégré comprenant :
une première porte d'entrée (G221) ayant une première borne d'entrée connectée au signal d'inversion d'une horloge, une deuxième borne d'entrée et une première borne de sortie ;
une deuxième porte d'entrée (G222) ayant une troisième borne d'entrée connectée au signal d'inversion de l'horloge, une quatrième borne d'entrée et une deuxième borne de sortie ;
un premier circuit basculeur (110) ayant une cinquième borne d'entrée connectée à ladite première borne de sortie, une sixième borne d'entrée connectée à ladite deuxième borne de sortie, une troisième borne de sortie servant à délivrer un signal de sortie inversé de ladite cinquième borne d'entrée, et une quatrième borne de sortie servant à délivrer un signal de sortie inversé de ladite sixième borne d'entrée ;
une première porte de sortie (G125) ayant une septième borne d'entrée connectée à ladite troisième borne de sortie, une huitième borne d'entrée connectée à ladite horloge, une neuvième borne d'entrée connectée à ladite deuxième borne de sortie et une cinquième borne de sortie ;
une deuxième porte de sortie (G126) ayant une dixième borne d'entrée connectée à ladite quatrième borne de sortie, une onzième borne d'entrée connectée à ladite horloge, une douzième borne d'entrée connectée à ladite première borne de sortie et une sixième borne de sortie ;
un deuxième circuit basculeur (150) ayant une treizième borne d'entrée connectée à ladite cinquième borne de sortie, une quatorzième borne d'entrée connectée à ladite sixième borne de sortie, une septième borne de sortie servant à délivrer un signal de sortie inversé de ladite treizième borne d'entrée et une huitième borne de sortie servant à délivrer un signal de sortie inversé de ladite quatorzième horne d'entrée, ladite septième borne de sortie étant connectée à ladite quatrième borne d'entrée et ladite huitième borne de sortie étant connectée à ladite deuxième horne d'entrée ;
une troisième porte de sortie (G321) ayant une quinzième borne d'entrée connectée à ladite septième borne de sortie, une seizième borne d'entrée connectée à ladite sixième borne de sortie et une neuvième borne de sortie ; et
une quatrième porte de sortie (G322) ayant une dix-septième borne d'entrée connectée à ladite huitième borne de sortie, une dix-huitième borne d'entrée connectée à ladite cinquième borne de sortie et une dixième borne de sortie.

2. Circuit intégré selon la revendication 1, où au moins une desdites portes d'entrée, desdites bascules et desdites portes de sortie comporte une porte NON-ET.

3. Circuit intégré selon la revendication 1, où au moins une desdites portes d'entrée, desdites bascules et desdites portes de sortie comporte une porte NI.
